# EUROPEAN PATENT APPLICATION

(11) **EP 4 648 111 A1**
(43) Date of publication of application: **12.11.2025**
(21) Application number: 23922368.8
(22) Date of filing: 01.11.2023
(51) Int. Cl.: H01L 29/423, H01L 29/739

(54) **REVERSE-CONDUCTING INSULATED-GATE BIPOLAR TRANSISTOR AND PREPARATION METHOD THEREFOR**

(30) Priority: 13.02.2023 CN 202310116479
(71) Applicant: Gree Electric Appliances, Inc. of Zhuhai, Zhuhai, Guangdong 519070 (CN)
(72) Inventor: ZHANG, Fusheng, Zhuhai, Guangdong 519070 (CN); XIE, Zixiang, Zhuhai, Guangdong 519070 (CN); LI, Chunyan, Zhuhai, Guangdong 519070 (CN); LIAO, Yongbo, Zhuhai, Guangdong 519070 (CN); MA, Yingjiang, Zhuhai, Guangdong 519070 (CN)
(74) Representative: Zacco GmbH
(86) International application number: PCT/CN2023/129176
(87) International publication number: WO 2024/169252

(57) **Abstract**

A reverse-conducting insulated gate bipolar transistor and a preparation method therefor are provided. The reverse-conducting insulated gate bipolar transistor includes: a drift region (1) doped with a first conductivity type, a base region (2) doped with a second conductivity type, and a plurality of trenches (3) extending into the drift region (1) from a surface of the drift region (1) and arranged in parallel. The trenches (3) penetrate the base region (2), and bottoms of the trenches (3) are in contact with the drift region (1). An insulating dielectric layer (31) and a conductive material (32) surrounded by the insulating dielectric layer (31) are arranged in each trench (3). The base region (2) includes active regions (21) and dummy regions (22) that are distributed in a staggered manner. An emitter region (41) corresponding to each active region (21), a contact region (42), the base region (2) adjacent to the contact region (42), the drift region (1), and a collector region (71) form an insulated gate bipolar transistor (IGBT) unit. The base region (2) corresponding to dummy regions (22), the contact region (42) adjacent to the base region (2), the drift region (1), and a cathode region (72) form a reverse recovery transistor unit, where a groove (33) is formed in the insulating dielectric layer (31) of each trench (3) located in the dummy regions (22). Without significantly increasing processes and costs, the reverse recovery performance of the RC-IGBT is optimized, and the turn-off loss of a diode is reduced.

## Description

### Cross-Reference to Related Application

The present disclosure is based on Chinese patent application No. 202310116479.4, filed on February 13, 2023 and entitled "REVERSE-CONDUCTING INSULATED GATE BIPOLAR TRANSISTOR AND PREPARATION METHOD THEREFOR", which is incorporated into this application by reference in its entirety.

### Technical Field

The present disclosure relates to the technical field of semiconductors, and in particular to, a reverse-conducting insulated gate bipolar transistor and a preparation method therefor.

### Background

An insulated gate bipolar transistor (IGBT) is a key semiconductor element in an electronic system, and is widely used in various medium- and high-voltage power control systems, such as motor driving and electric energy conversion. An IGBT device includes three electrodes: a collector, an emitter, and a gate for controlling turning on or turning off of the device. The IGBT of the related technology is equivalent to a PNP transistor with an open base region when the gate is turned off, so it does not have a reverse freewheel capability. As a result, the IGBT of the related technology is only a unidirectional conducting device, that is, current can only flow from the collector to the emitter. However, most power circuit systems have a requirement for bidirectional current conduction. Therefore, in recent years, a new type of reverse-conducting insulated gate bipolar transistor (RC-IGBT) structure has been provided.

Compared with the IGBT of the related technology, the RC-IGBT integrates a reverse parallel diode and the IGBT of the related technology on the same chip, so that current of the RC-IGBT can flow from the collector to the emitter or from the emitter to the collector, to replace a reverse parallel separated freewheel diode device of the IGBT of the related technology, thereby saving about 1/3 of a total chip area and significantly reducing the production costs and package testing costs of the chip. Meanwhile, this integrated diode structure can reduce the thermal resistance of the diode and significantly improve its surge current resistance. Meanwhile, it can significantly reduce the disadvantage of large fluctuations in a chip junction temperature and improve the power cycling capability of the device.

However, since the diode and the IGBT are integrated on the same chip, the RC-IGBT has the problem of poor reverse recovery performance of the diode. If a carrier lifetime control technology is used to improve a reverse recovery speed of the diode and reduce the reverse recovery loss, adverse effects may be generated on the performance and reliability of the IGBT in an operating mode.

### Summary

The present disclosure aims to provide a reverse-conducting insulated gate bipolar transistor (RC-IGBT) and a preparation method therefor, which can optimize the reverse recovery performance of the RC-IGBT and reduce the turn-off loss of a diode without significantly increasing processes and costs.

In a first aspect, an embodiment of the present disclosure provides a reverse-conducting insulated gate bipolar transistor, including: a drift region doped with a first conductivity type; a base region that is formed on a surface of the drift region and is doped with a second conductivity type, where the base region includes active regions and dummy regions that are staggered; and a plurality of trenches extending from the surface of the drift region into the drift region and are arranged in parallel, where the trenches penetrate through the base region, and bottoms of the trenches are in contact with the drift region; an insulating dielectric layer and a conductive material surrounded by the insulating dielectric layer are arranged in each trench; the conductive material is led out from a first metal layer at a top to form a gate; an emitter region heavily doped with the first conductivity type and a contact region heavily doped with the second conductivity type are formed on a surface of each active region of the base region; a first side surface of the emitter region is adjacent to a side surface of the corresponding trench, and a second side surface of the emitter region is adjacent to the contact region; the emitter region and the contact region are jointly led out from the first metal layer to form an emitter; a buffer layer doped with the first conductivity type is formed on a back surface of the drift region; a collector region heavily doped with the second conductivity type and a cathode region heavily doped with the first conductivity type are formed on a surface of the buffer layer and are staggered; the collector region and the cathode region are jointly led out from a second metal layer to form a collector; the emitter region corresponding to the each active region, the contact region, the base region adjacent to the contact region, the drift region, and the collector region form an insulated gate bipolar transistor (IGBT) unit; each dummy region serves as a transistor anode region; and the base region corresponding to the transistor anode region, the contact region adjacent to the base region, the drift region, and the cathode region form a reverse recovery transistor unit, where a groove is formed in the insulating dielectric layer of each trench located in the dummy regions.

In an exemplary embodiment, a depth of each groove is 0.8 µm ± 0.1 µm.

In an exemplary embodiment, an oxide layer is further formed between the first metal layer and tops of the plurality of trenches.

In an exemplary embodiment, the reverse-conducting insulated gate bipolar transistor further includes a carrier storage layer located between the drift region and the base region, and the carrier storage layer is adjacent to a side surface of the adjacent trench.

In an exemplary embodiment, a material of the insulating dielectric layer is silicon dioxide, and a material of the conductive material is polycrystalline silicon.

In an exemplary embodiment, any one of the first conductivity type and the second conductivity type is an n type, and the other one of the first conductivity type and the second conductivity type is a p type.

In a second aspect, an embodiment of the present disclosure provides a preparation method for the reverse-conducting insulated gate bipolar transistor, including: A drift region doped with a first conductivity type is formed. A base region doped with a second conductivity type is formed on an upper surface of the drift region by at least one of ion implantation and diffusion, where the base region includes active regions and dummy regions that are staggered. The upper surface of the drift region is etched to form a plurality of trenches that are arranged in parallel, where the trenches penetrate through the base region, and bottoms of the trenches are in contact with the drift region. An insulating dielectric layer is formed on an inner wall of each trench, and the trench is filled with a conductive material. A groove is formed in the insulating dielectric layer of each trench located in the dummy regions by dry etching. An emitter region heavily doped with the first conductivity type and a contact region heavily doped with the second conductivity type are formed on an upper surface of each active region of the base region by at least one of ion implantation and diffusion. A first metal layer is deposited on surfaces of the emitter region and the contact region, where a top of the conductive material is led out from the first metal layer to form a gate, and the emitter region and the contact region are jointly led out from the first metal layer to form an emitter. A back surface of the drift region is thinned, and a buffer layer doped with the first conductivity type is formed by at least one of deep ion implantation and diffusion. First conductivity type shallow ion implantation is performed on a surface of the buffer layer to form a cathode region heavily doped with the first conductivity type. Second conductivity type shallow ion implantation is performed on the surface of the buffer layer to form a collector region heavily doped with the second conductivity type, where the collector region and the cathode region are staggered. A second metal layer is deposited on surfaces of the collector region and the cathode region, where the collector region and the cathode region are jointly led out from the second metal layer to form a collector.

In an exemplary embodiment, before the depositing the first metal layer, the preparation method further includes: forming an oxide layer formed on tops of the plurality of trenches.

In an exemplary embodiment, before the forming the base region, the preparation method further includes: forming a carrier storage layer doped with the first conductivity type on a surface of the drift region by at least one of deep ion injection and diffusion, where the trenches penetrate through the carrier storage layer.

In an exemplary embodiment, gas for the dry etching is any one of octafluorocyclopentene, carbon tetrafluoride, and trifluoromethane.

According to the reverse-conducting insulated gate bipolar transistor and the preparation method therefor that are provided in the embodiments of the present disclosure. The base region doped with the second conductivity type is formed on the surface of the drift region doped with the first conductivity type. The base region includes the active regions and the dummy regions that are staggered. The plurality of trenches extending from the surface of the drift region into the drift region and are arranged in parallel penetrate through the base region, and the bottoms of the trenches are in contact with the drift region. The insulating dielectric layer and the conductive material surrounded by the insulating dielectric layer are arranged in each trench. The conductive material is led out from the first metal layer at the top to form the gate. The emitter region heavily doped with the first conductivity type and the contact region heavily doped with the second conductivity type are formed on the surface of each active region of the base region. The first side surface of the emitter region is adjacent to the side surface of the corresponding trench, and the second side surface of the emitter region is adjacent to the contact region. The emitter region and the contact region are jointly led out from the first metal layer to form the emitter. The buffer layer doped with the first conductivity type is formed on the back surface of the drift region. The collector region heavily doped with the second conductivity type and the cathode region heavily doped with the first conductivity type are formed on the surface of the buffer layer and are staggered. The collector region and the cathode region are jointly led out from the second metal layer to form the collector. The contact region corresponding to the each active region, the emitter region, a trench adjacent to the emitter region, the base region, the drift region, and the collector region form the IGBT unit. The each dummy region serves as the transistor anode region. A trench corresponding to the transistor anode region, the base region, the drift region, and the cathode region form the reverse recovery transistor unit, where the groove is formed in the insulating dielectric layer of each trench located in the dummy regions. Therefore, without significantly increasing processes and costs, by etching the insulating dielectric layer of each trench in the dummy regions to form the groove, a concentration of electron holes nearby can be reduced, thereby reducing the carrier injection efficiency, optimizing the reverse recovery performance of the RC-IGBT, and reducing the turn-off loss of a diode.

### Brief Description of the Drawings

To describe the technical solutions in the embodiments of the present disclosure or in the existing technology more clearly, the following briefly introduces the accompanying drawings for describing the embodiments or the existing technology. Apparently, the accompanying drawings in the following description show some embodiments of the present disclosure, and a person of ordinary skill in the art may still derive other drawings from the accompanying drawings without creative efforts. In addition, in the accompanying drawings, the same parts are marked with the same numerals, and the accompanying drawings are not drawn to an actual scale.
FIG. 1 is a schematic structural diagram of a reverse-conducting insulated gate bipolar transistor provided in an embodiment of the present disclosure;
FIG. 2 is a partially enlarged structural diagram of a dummy region of the reverse-conducting insulated gate bipolar transistor shown in FIG. 1;
FIG. 3 is a schematic diagram of reverse recovery waveform simulation of the reverse-conducting insulated gate bipolar transistor shown in FIG. 1; and
FIG. 4 is a scatter diagram of a balance relationship between a reverse breakdown voltage and reverse recovery loss of the reverse-conducting insulated gate bipolar transistor shown in FIG. 1.

Descriptions of reference numerals:
1: drift region; 2: base region; 21: active region; 22: dummy region; 3: trench; 30: carrier storage layer;
31: insulating dielectric layer; 32: conductive material; 33: groove; 41: emitter region; 42: contact region; 5: first metal layer; 50: oxide layer; 6: buffer layer; 71: collector region; 72: cathode region; 8: second metal layer; G: gate; E: emitter; and C: collector.

### Detailed Description of the Embodiments

In order to make the objectives, technical solutions, and advantages of the embodiments of the present disclosure clearer, the technical solutions in the embodiments of the present disclosure are clearly described below with reference to the accompanying drawings in the embodiments of the present disclosure. Apparently, the described embodiments are some rather than all of the embodiments of the present disclosure. All other embodiments obtained by a person of ordinary skill in the art based on the embodiments of the present disclosure without making creative efforts shall fall within the protection scope of the present disclosure.

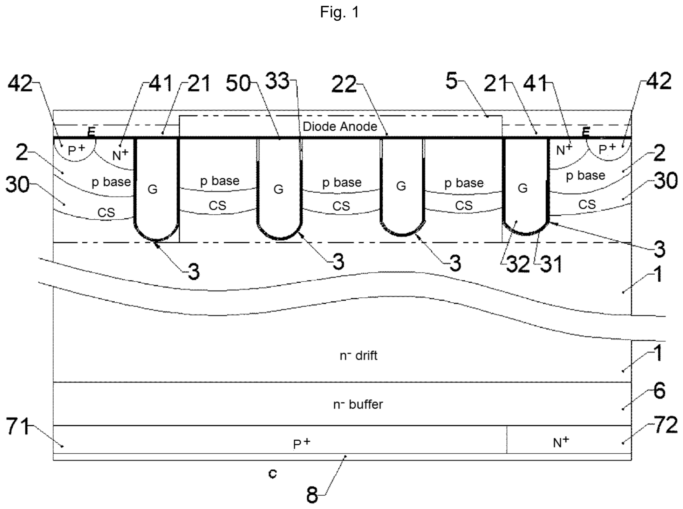

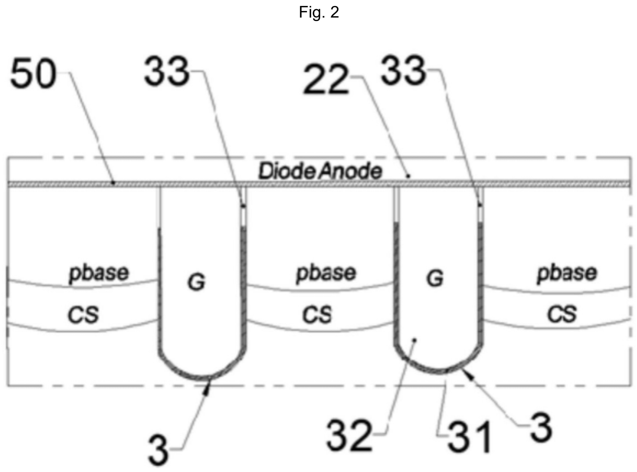

FIG. 1 is a schematic structural diagram of a reverse-conducting insulated gate bipolar transistor provided in an embodiment of the present disclosure, and FIG. 2 is a partially enlarged structural diagram of a dummy region of the reverse-conducting insulated gate bipolar transistor shown in FIG. 1.

As shown in FIG. 1 and FIG. 2, the reverse-conducting insulated gate bipolar transistor (hereinafter referred to as RC-IGBT) provided in an embodiment of the present disclosure includes:
a drift region 1 doped with a first conductivity type;
a base region 2 that is formed on a surface of the drift region 1 and is doped with a second conductivity type, where the base region 2 includes active regions 21 and dummy regions 22 that are staggered; and
a plurality of trenches 3 extending from the surface of the drift region 1 into the drift region 1 and are arranged in parallel, where the trenches 3 penetrate through the base region 2, and bottoms of the trenches 3 are in contact with the drift region 1; an insulating dielectric layer 31 and a conductive material 32 surrounded by the insulating dielectric layer 31 are arranged in each trench 3; and the conductive material 32 is led out from a first metal layer 5 at a top to form a gate G.

An emitter region 41 heavily doped with the first conductivity type and a contact region 42 heavily doped with the second conductivity type are formed on a surface of each active region 21 of the base region 2; a first side surface of the emitter region 41 is adjacent to a side surface of the corresponding trench 3, and a second side surface of the emitter region 41 is adjacent to the contact region 42; and the emitter region 41 and the contact region 42 are jointly led out from the first metal layer 5 to form an emitter E.

A buffer layer 6 doped with the first conductivity type is formed on a back surface of the drift region 1.

A collector region 71 heavily doped with the second conductivity type and a cathode region 72 heavily doped with the first conductivity type are formed on a surface of the buffer layer 6 and are staggered. Te collector region 71 and the cathode region 72 are jointly led out from a second metal layer 8 to form a collector C.

The emitter region 41 corresponding to the each active region 21, the contact region 42, the base region 2 adjacent to the contact region 42, the drift region 1, and the collector region 71 form an IGBT unit.

Each dummy region 22 serves as a transistor anode region; and the base region 2 corresponding to the transistor anode region, the contact region 42 adjacent to the base region 2, the drift region 1, and the cathode region 72 form a reverse recovery transistor unit.

A groove 33 is formed in the insulating dielectric layer 31 of each trench 3 located in the dummy regions 22.

It should be noted that in this embodiment of the present disclosure, any one of the first conductivity type and the second conductivity type is an n type, and the other one of the first conductivity type and the second conductivity type is a p type. A semiconductor substrate of the device is considered as being made of a silicon (Si) material. However, the substrate can also be made of any other material suitable for manufacturing the RC-IGBT, such as germanium (Ge) and silicon carbide (SiC). In the following description, a material of the insulating dielectric layer of the device can be composed of silicon oxide (SiOₓ), but other dielectric materials such as silicon nitride (SiₓN_{y}), aluminum oxide (AlₓO_{y}), and silicon oxynitride (SiₓN_{y}O_{z}) can also be used. In the following description, a p-type conductive semiconductor region can be formed by doping one or several impurities into an original semiconductor region, and these impurities may be, but are not limited to: boron (B), aluminum (Al), gallium (Ga), and the like. An n-type conductive semiconductor region can be formed by doping one or several impurities into an original semiconductor region, and these impurities may be, but are not limited to: phosphorus (P), arsenic (As), tellurium (Sb), selenium (Se), proton (H⁺), and the like. In the following description, a heavily doped p-type conductive semiconductor region is labeled as a p+ region, and a heavily doped n-type conductive semiconductor region is labeled as an n+ region. For example, in the silicon substrate, unless otherwise specified, an impurity concentration of a heavily doped region is generally between 1 × 1019cm⁻³ and 1 × 1021cm⁻³. In the following description, a lightly doped p-type conductive semiconductor region is labeled as a p- region, and a lightly doped n-type conductive semiconductor region is labeled as an n- region. For example, in the silicon substrate, unless otherwise specified, an impurity concentration of a lightly doped region is generally between 1 × 1012cm⁻³ and 1 × 1015cm⁻³.

In addition, the following embodiments will describe an RC-IGBT device using an n-type metal oxide semiconductor (MOS) channel, where a first conductivity type is an n type and a second conductivity type is a p type. However, it should be noted that the present disclosure is also applicable to an RC-IGBT device using a p-type MOS channel.

As shown in FIG. 1, the drift region 1 is obtained by lightly doping n-, and the base region 2 is obtained by performing p-type doping based on the drift region 1. The emitter region 41 is obtained by heavily doping n+, and the contact region 42 is obtained by heavily doping p+. The buffer layer 6 is obtained by lightly doping n-. The collector region 71 is obtained by heavily doping p+, and the cathode region 72 is obtained by heavily doping n+. Optionally, a material of the insulating dielectric layer 31 is silicon dioxide SiO₂, and a material of the conductive material 32 is polycrystalline silicon Si.

The plurality of trenches 3 extend from the surface of the drift region 1 into the drift region 1 and are arranged in parallel, such as four trenches 3 shown in FIG. 1. The trenches 3 penetrate through the base region 2, and the bottoms of the trenches 3 are in contact with the drift region 1. The insulating dielectric layer 31 and the conductive material 32 surrounded by the insulating dielectric layer 31 are arranged inside each trench 3. The conductive material 32 is led out from the first metal layer 5 at the top to form the gate G. In addition, the active regions 21 and the dummy regions 22 are alternately distributed in a transverse direction of the device. Some trenches 3 are located in the active regions 21, for example, two trenches 3 shown in FIG. 1 are located in the active regions 21. Some trenches 3 are located in the dummy regions 22, for example, two trenches 3 shown in FIG. 1 are located in the dummy region 22.

As shown in FIG. 2, the dummy region 22 has process parameters consistent with process parameters of the active regions 21, except that there is no n+ heavily doped region inside and there is no emitter region led out. The dummy region 22 can be used as an anode of a reverse diode path. A main function of the dummy region 22 is to reduce a current gain of a trench gate IGBT, decrease an amplitude value of short-circuit current of the IGBT, shield a peak electric field of a diode, and improve the short-circuit reliability. Further, the insulating dielectric layers 31 of the trenches 3 within the dummy region 22 are etched with the grooves 33, and the insulating dielectric layers 31 of the trenches 3 within the active regions 21 are not etched with grooves 33.

A working principle of the RC-IGBT device in this embodiment of the present disclosure is as follows: The RC-IGBT device includes three electrodes: the emitter E located at a top, and the collector C and the gate G that are located at a bottom. The gate G, the insulating dielectric layers 31, the p base region 2, the n+ type emitter region 41, the p+ contact region 42, and the n- drift region 1 jointly constitute a metal-oxide-semiconductor (hereinafter referred to as "MOS") structure. In addition, the p base region 2, the n- drift region 1, and the p+ collector region 71 on the back surface jointly constitute a PNP bipolar transistor. The MOS structure and the PNP transistor jointly form an IGBT structure, so that the MOS structure can be used to control current of the PNP transistor to flow from the collector C to the emitter E. This is referred to as forward conduction of RC-IGBT current. On the other hand, the p+ contact region 42, the p base region 2, the n- drift region 1, and the n+ cathode region 72 on the back surface jointly constitute a P-I-N diode (i.e., a reverse recovery transistor unit), where the p+ contact region 42 and p base region 2 serve as an anode of the P-I-N diode, and the n+ cathode region 72 serves as a cathode of the P-I-N diode. When a voltage of the emitter E of the RC-IGBT device exceeds a preset voltage value of the collector C, the P-I-N diode can be turned on, thereby causing current flow from the emitter E to the collector C. This is referred as backward conduction of RC-IGBT current.

When the RC-IGBT device is in a backward conduction state, there are two conductive paths: In a first conductive path, the current flows from the p base region 2 on the front surface to the n-drift region 1, then passes through the n- buffer layer 6, and finally flows out from the back n+ cathode region 72. The device is equivalent to a PIN diode structure. Conductivity modulation is performed inside the n- drift region 1 by holes injected from the front surface and electrons injected from the back surface. In this case, a reverse conduction voltage fall (VF) is relatively low. In a second conductive path, the current passes through an MOS source region on the front surface, an n-type channel region, the n- drift region 1, and the n- buffer layer 6, and finally flows out from the n+ cathode region 72 on the back surface. The device is equivalent to an n-channel metal-oxide-semiconductor field effect transistor (MOSFET) structure. In this case, the device is in both a PIN operating and an MOSFET operating mode. Injection of electron carriers into an n-channel on the front surface suppresses hole injection into the p base region of the diode on the front surface, so that the conductivity modulation in the n- drift region is weakened, and the reverse conduction voltage fall (VF) of the device can increase.

Therefore, after the insulating dielectric layers 31 of the trenches 3 in the dummy regions 22 are etched to form the grooves 33, when the diode undergoes reverse recovery, using the grooves 33 can reduce the concentration of electron holes nearby, thereby reducing the carrier injection efficiency, optimizing the reverse recovery performance of the RC-IGBT, and reducing the turn-off loss of the diode.

According to the reverse-conducting insulated gate bipolar transistor provided in the embodiments of the present disclosure, the base region 2 doped with the second conductivity type is formed on the surface of the drift region 1 doped with the first conductivity type. The base region 2 includes the active regions 21 and the dummy regions 22 that are staggered. The plurality of trenches 3 extending from the surface of the drift region 1 into the drift region 1 and are arranged in parallel penetrate through the base region 2, and the bottoms of the trenches 3 are in contact with the drift region 1. The insulating dielectric layer 31 and the conductive material 32 surrounded by the insulating dielectric layer 31 are arranged in each trench 3. The conductive material 32 is led out from the first metal layer 5 at the top to form the gate G. The emitter region 41 heavily doped with the first conductivity type and the contact region 42 heavily doped with the second conductivity type are formed on the surface of the each active region 21 of the base region 2. The first side surface of the emitter region 41 is adjacent to the side surface of the corresponding trench 3, and the second side surface of the emitter region 41 is adjacent to the contact region 42. The emitter region 41 and the contact region 42 are jointly led out from the first metal layer 5 to form the emitter E. The buffer layer 6 doped with the first conductivity type is formed on the back surface of the drift region 1. The collector region 71 heavily doped with the second conductivity type and the cathode region 72 heavily doped with the first conductivity type are formed on the surface of the buffer layer 6 and are staggered. The collector region 71 and the cathode region 72 are jointly led out from the second metal layer 8 to form the collector C. The contact region 42 corresponding to the each active region 21, the emitter region 41, a trench 3 adjacent to the emitter region 41, the base region 2, the drift region 1, and the collector region 7 form the IGBT unit. The each dummy region 22 serves as the transistor anode region. A trench 3 corresponding to the transistor anode region, the base region 2, the drift region 1, and the cathode region 72 form the reverse recovery transistor unit, where the groove 33 is formed in the insulating dielectric layer 31 of each trench 3 located in the dummy regions 22. Therefore, without significantly increasing processes and costs, by etching the insulating dielectric layer 31 of each trench 3 in the dummy regions 22 to form the groove 33, a concentration of electron holes nearby can be reduced, thereby reducing the carrier injection efficiency, optimizing the reverse recovery performance of the RC-IGBT, and reducing the turn-off loss of a diode.

In some embodiments, a depth of each groove 33 is 0.8 µm ± 0.1 µm.

As shown in FIG. 2, the insulating dielectric layers 31 of the trenches 3 in the dummy regions 22 are etched with the grooves 33. An optimization test needs to be performed on the depth d of each groove 33. If the depth d is too large, the stability and reliability of the device may decrease, while if the depth d is too small, the adjustment effect on carriers is not significant.

The present disclosure performs simulation design analysis on the RC-IGBT under conditions that a reverse breakdown voltage is 600 V and a current is 5 A. It is obtained that when the depth of each groove 33 is 0.8 µm ± 0.1 µm, the carrier injection efficiency meets a design requirement, which can optimize the reverse recovery performance of the RC-IGBT and reduce the turn-off loss of the diode.

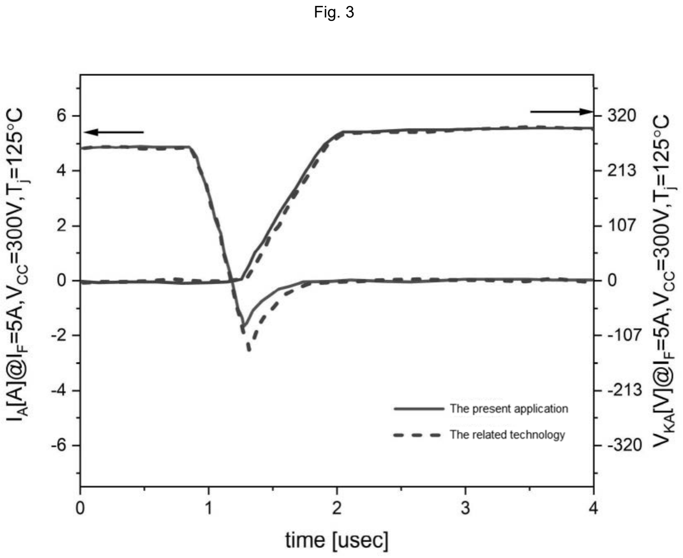

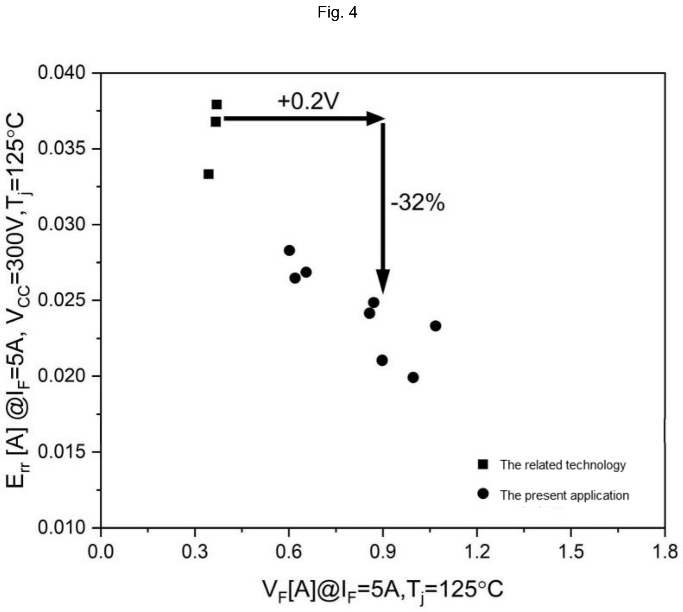

FIG. 3 is a schematic diagram of reverse recovery waveform simulation of the reverse-conducting insulated gate bipolar transistor shown in FIG. 1; and FIG. 4 is a scatter diagram of a balance relationship between a reverse breakdown voltage and reverse recovery loss of the reverse-conducting insulated gate bipolar transistor shown in FIG. 1.

As shown in FIG. 3, the solid line curve represents an RC-IGBT structure provided by this embodiment of the present disclosure, and the dashed line curve represents an RC-IGBT structure of the related technology. It can be seen that under the same conditions, turn-off charges of the RC-IGBT structure of this embodiment of the present disclosure are less than turn-off charges of the RC-IGBT structure of the related technology. As shown in FIG. 4, the circular dots represent the RC-IGBT structure of this embodiment of the present disclosure, and the square dots represent the RC-IGBT structure of the related technology. It can be seen that although the reverse breakdown VF of the RC-IGBT structure of this embodiment of the present disclosure is slightly increased by 0.2 V relative to the RC-IGBT structure of the related technology, the reverse recovery loss Err of the RC-IGBT structure of this embodiment of the present disclosure is reduced by 32% relative to the RC-IGBT structure of the related technology.

In addition, the grooves 33 are made by dry etching. Etching gas can be any one of octafluorocyclopentene (C5F8), carbon tetrafluoride (CF4), and trifluoromethane (CHF3). The high selectivity of the etching gas for SiO₂/Si contributes to the formation of the grooves 33. In order to optimize the etching performance, such as an etching rate, an SiO₂/Si selectivity, and etching profile control, it needs to ensure that gas with high selectivity for SiO₂/Si does not affect an IGBT region. When the diode undergoes reverse recovery, the grooves 33 are used to improve the overall reverse recovery performance of the device and reduce the reverse recovery loss.

In some embodiments, an oxide layer 50 is further formed between the first metal layer 5 and tops of the plurality of trenches 3. The oxide layer 50 can be provided with a contact via, so that the conductive materials 32 of the trenches 3 are connected to the first metal layer 5 through the contact via to form the gate G. In addition, the oxide layer 50 further covers the emitter region 41 and the contact region 42, and the emitter region 41 and the contact region 42 are connected to the first metal layer 5 through the contact via to form the emitter E.

In some embodiments, the RC-IGBT further includes a carrier storage (CS) layer 30 located between the drift region 1 and the base region 2, and the carrier storage layer 30 is adjacent to a side surface of the adjacent trench 3. The function of the carrier storage layer 30 is to reduce the hole injection efficiency in an operating state of the diode and increase the emitter carrier concentration in an operating state of the IGBT, thereby reducing the conduction voltage fall.

In addition, an embodiment of the present disclosure further provides a preparation method for the reverse-conducting insulated gate bipolar transistor, including the following steps S1 to S11:
Step S1: A drift region 1 doped with a first conductivity type is formed.
Step S2: A base region 2 doped with a second conductivity type is formed on an upper surface of the drift region 1 by ion implantation and/or diffusion, where the base region 2 includes active regions 21 and dummy regions 22 that are staggered.
Step S3: The upper surface of the drift region 1 is etched to form a plurality of trenches 3 that are arranged in parallel, where the trenches 3 penetrate through the base region 2, and bottoms of the trenches 3 are in contact with the drift region 1.
Step S4: An insulating dielectric layer 31 is formed on an inner wall of each trench 3, and the trench 3 is filled with a conductive material 32.
Step S5: A groove 33 is formed in the insulating dielectric layer 31 of each trench 3 located in the dummy regions 22 by dry etching.
Step S6: An emitter region 41 heavily doped with the first conductivity type and a contact region 42 heavily doped with the second conductivity type are formed on an upper surface of each active region 21 of the base region 2 by ion implantation and/or diffusion.
Step S7: A first metal layer 5 is deposited on surfaces of the emitter region 41 and the contact region 42, where the conductive material 32 is led out from the first metal layer 5 at a top to form a gate G, and the emitter region 41 and the contact region 42 are jointly led out from the first metal layer 5 to form an emitter E.
Step S8: A back surface of the drift region 1 is thinned, and a buffer layer 6 doped with the first conductivity type is formed by deep ion implantation and/or diffusion.
Step S9: First conductivity type shallow ion implantation is performed on a surface of the buffer layer 6 to form a cathode region 72 heavily doped with the first conductivity type.
Step S10: Second conductivity type shallow ion implantation is performed on the surface of the buffer layer 6 to form a collector region 71 heavily doped with the second conductivity type, where the collector region 71 and the cathode region 72 are staggered.
Step S11: A second metal layer 8 is deposited on surfaces of the collector region 71 and the cathode region 72, where the collector region 71 and the cathode region 72 are jointly led out from the second metal layer 8 to form a collector C.

In some embodiments, before the depositing the first metal layer 5, the preparation method further includes: An oxide layer 50 is formed on tops of the plurality of trenches 3. The oxide layer 50 can be provided with a contact via, so that the conductive materials 32 of the trenches 3 are connected to the first metal layer 5 through the contact via to form the gate G. In addition, the oxide layer 50 further covers the emitter region 41 and the contact region 42, and the emitter region 41 and the contact region 42 are connected to the first metal layer 5 through the contact via to form the emitter E.

In some embodiments, before the forming the base region 2, the preparation method further includes: A carrier storage layer 30 doped with the first conductivity type is formed on a surface of the drift region 1 by deep ion injection and/or diffusion, where the trenches 3 penetrate through the carrier storage layer 30. The function of the carrier storage layer 30 is to reduce the hole injection efficiency in an operating state of the diode and increase the emitter carrier concentration in an operating state of the IGBT, thereby reducing the conduction voltage fall.

In some embodiments, gas for the dry etching is any one of octafluorocyclopentene, carbon tetrafluoride, and trifluoromethane. The high selectivity of the etching gas for SiO₂/Si contributes to the formation of the grooves 33. In order to optimize the etching performance, such as an etching rate, an SiO₂/Si selectivity, and etching profile control, it needs to ensure that gas with high selectivity for SiO₂/Si does not affect an IGBT region. When the diode undergoes reverse recovery, the grooves 33 are used to improve the overall reverse recovery performance of the device and reduce the reverse recovery loss.

It should be noted that according to the above preparation method, the RC-IGBT device of this embodiment of the present disclosure does not require an additional photolithography mask when compared with the RC-IGBT device of the related technology, so that the manufacturing costs are not increased.

According to the preparation method for the reverse-conducting insulated gate bipolar transistor provided in the embodiments of the present disclosure, the grooves 33 are provided in the insulating dielectric layers 31 of the trenches 3 located in the dummy regions 22, without significantly increasing processes and costs, by etching the insulating dielectric layers 31 of the trenches 3 in the dummy regions 22 to form the grooves 33, an electron hole concentration nearby can be reduced, thereby reducing the carrier injection efficiency, optimizing the reverse recovery performance of the RC-IGBT, and reducing the turn-off loss of a diode.

It should be noted that the terms "one embodiment", "embodiments", "exemplary embodiments", "some embodiments", and the like in this specification indicate that the embodiments may include particular features, structures, or characteristics, but not every embodiment includes the particular specific features, structures, or characteristics. In addition, such phrases may not necessarily be the same embodiment. In addition, when particular features, structures, or characteristics are described with reference to the embodiments, it is within the knowledge scope of those skilled in the art to implement such features, structures, or characteristics with reference to other embodiments that are explicitly or implicitly described.

It should be easily understood that the terms "on", "above", and "over" in the present disclosure should be interpreted in the widest possible way, so that "on" not only means "directly on an object", but also means "on an object" with an intermediate feature or layer therebetween, and "above" or "over" not only mean "on or above an object", but also mean "on something "on or above an object" without an intermediate feature or layer therebetween (i.e., directly on an object).

It should be noted that in this document, relationship terms such as "first" and "second" are used solely to distinguish one entity or operation from another entity or operation without necessarily requiring or implying any actual such relationship or order between such entities or operations. Furthermore, the terms "include", "including", or any other variation thereof, are intended to encompass a non-exclusive inclusion, such that a process, method, article, or device that includes a list of elements does not include only those elements but may include other elements not explicitly listed or inherent to such process, method, article, or device. Without further limitation, an element defined by the phrase "including a/an..." does not exclude the presence of another identical elements in the process, method, article or device that includes the element.

It should be finally noted that: The foregoing various embodiments are merely intended to describe the technical solutions of the present disclosure, but not for limiting the present disclosure. Although the present disclosure is described in detail with reference to the foregoing various embodiments, persons of ordinary skill in the art should understand that they may still make modifications to the technical solutions described in the foregoing embodiments or make equivalent replacements to partial or all technical features thereof. However, these modifications or replacements do not make the essence of the corresponding technical solutions depart from the scope of the technical solutions of the various embodiments of the present disclosure.

## Claims

1. A reverse-conducting insulated gate bipolar transistor, comprising:
a drift region doped with a first conductivity type;
a base region that is formed on a surface of the drift region and is doped with a second conductivity type, wherein the base region comprises active regions and dummy regions that are staggered; and
a plurality of trenches extending from the surface of the drift region into the drift region and are arranged in parallel, wherein the trenches penetrate through the base region, and bottoms of the trenches are in contact with the drift region; an insulating dielectric layer and a conductive material surrounded by the insulating dielectric layer are arranged in each trench; the conductive material is led out from a first metal layer at a top to form a gate;
an emitter region heavily doped with the first conductivity type and a contact region heavily doped with the second conductivity type are formed on a surface of each active region of the base region; a first side surface of the emitter region is adjacent to a side surface of the corresponding trench, and a second side surface of the emitter region is adjacent to the contact region; the emitter region and the contact region are jointly led out from the first metal layer to form an emitter;
a buffer layer doped with the first conductivity type is formed on a back surface of the drift region;
a collector region heavily doped with the second conductivity type and a cathode region heavily doped with the first conductivity type are formed on a surface of the buffer layer and are staggered; the collector region and the cathode region are jointly led out from a second metal layer to form a collector;
the emitter region corresponding to the each active region, the contact region, the base region adjacent to the contact region, the drift region, and the collector region form an insulated gate bipolar transistor (IGBT) unit;
each dummy region serves as a transistor anode region; and the base region corresponding to the transistor anode region, the contact region adjacent to the base region, the drift region, and the cathode region form a reverse recovery transistor unit,
wherein a groove is formed in the insulating dielectric layer of each trench located in the dummy regions.

2. The reverse-conducting insulated gate bipolar transistor according to claim 1, wherein a depth of each groove is 0.8 µm ± 0.1 µm.

3. The reverse-conducting insulated gate bipolar transistor according to claim 1, wherein an oxide layer is further formed between the first metal layer and tops of the plurality of trenches.

4. The reverse-conducting insulated gate bipolar transistor according to claim 1, further comprising a carrier storage layer located between the drift region and the base region, wherein the carrier storage layer is adjacent to a side surface of the adjacent trench.

5. The reverse-conducting insulated gate bipolar transistor according to claim 1, wherein a material of the insulating dielectric layer is silicon dioxide, and a material of the conductive material is polycrystalline silicon.

6. The reverse-conducting insulated gate bipolar transistor according to claim 1, wherein any one of the first conductivity type and the second conductivity type is an n type, and the other one of the first conductivity type and the second conductivity type is a p type.

7. A preparation method for the reverse-conducting insulated gate bipolar transistor according to any one of claims 1 to 6, comprising:
forming the drift region doped with the first conductivity type;
forming the base region doped with the second conductivity type on an upper surface of the drift region by at least one of ion implantation and diffusion, wherein the base region comprises the active regions and the dummy regions that are staggered;
etching the upper surface of the drift region to form the plurality of trenches that are arranged in parallel, wherein the trenches penetrate through the base region, and the bottoms of the trenches are in contact with the drift region;
forming the insulating dielectric layer on an inner wall of each trench, and filling the trench with the conductive material;
forming the groove in the insulating dielectric layer of the each trench located in the dummy regions by dry etching;
forming the emitter region heavily doped with the first conductivity type and the contact region heavily doped with the second conductivity type on an upper surface of the each active region of the base region by at least one of ion implantation and diffusion;
depositing the first metal layer on surfaces of the emitter region and the contact region, wherein a top of the conductive material is led out from the first metal layer to form the gate, and the emitter region and the contact region are jointly led out from the first metal layer to form the emitter;
thinning a back surface of the drift region and forming the buffer layer doped with the first conductivity type by at least one of deep ion implantation and diffusion;
performing first conductivity type shallow ion implantation on the surface of the buffer layer to form the cathode region heavily doped with the first conductivity type;
performing second conductivity type shallow ion implantation on the surface of the buffer layer to form the collector region heavily doped with the second conductivity type, wherein the collector region and the cathode region are staggered; and
depositing the second metal layer on surfaces of the collector region and the cathode region, wherein the collector region and the cathode region are jointly led out from the second metal layer to form the collector.

8. The preparation method according to claim 7, before the depositing the first metal layer, further comprising: forming an oxide layer formed on tops of the plurality of trenches.

9. The preparation method according to claim 7, before the forming the base region, further comprising: forming a carrier storage layer doped with the first conductivity type on a surface of the drift region by at least one of deep ion injection and diffusion, wherein the trenches penetrate through the carrier storage layer.

10. The preparation method according to claim 7, wherein gas for the dry etching is any one of octafluorocyclopentene, carbon tetrafluoride, and trifluoromethane.
